(19) **Europäisches Patentamt**
**European Patent Office**
**Office européen des brevets**

(11) **EP 2 226 945 A1**

(12) **EUROPEAN PATENT APPLICATION**

(43) Date of publication:
**08.09.2010 Bulletin 2010/36**

(51) Int Cl.:
**H03M 13/11** *(2006.01)* **H03M 13/03** *(2006.01)*

(21) Application number: **09100161.0**

(22) Date of filing: **03.03.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(71) Applicant: **Nokia Siemens Networks Oy**
**02610 Espoo (FI)**

(72) Inventor: **Cannalire, Giacomo Francesco**
**20062 Cassano d'Adda (IT)**

(74) Representative: **Fischer, Michael**
**Nokia Siemens Networks GmbH & Co. KG**
**COO RTP IPR, Patent Administration**
**80240 München (DE)**

(54) **Generation of optimized exponent matrices for multi-rate LDPC codes**

(57)    Generating parity-check exponent matrixes $H_{exp}$ for both coding sequences of information bits and decoding parity-check codewords, by using LDPC codes supporting different block sizes for each code-rate $R_j$, is optimized starting from a multi-rate random exponent table, the main table, from which sub-tables can be extracted for every requested code-rate. The generated exponent matrixes are built with random techniques, by which a first $r_b \times r_b$ deterministic sub-matrix accounting for a block of r redundancy bits is contiguous to a random $r_b \times k_b$ sub-matrix that accounts for a block of $k$ information bits. Some constraints on the elements of the first column vector Cv of deterministic matrix, and some other distance rules on the random elements must be respected in order to simplify the encoder and prevent unwanted cycles in Tanner's graph at the decoder, as done in IEEE Std 802.16e (WiMAX). The main table is devoted to the only random matrixes plus the first column vector of deterministic matrixes for many code-rates. The main table is derived from an original table that only includes random exponent values which respect the distance rules. The respect of constraints on Cv vectors is achieved by forcing the value of some specific elements of each vector to the requested ones. So doing, the distance rules are lost, but when a sub-table is extracted for a specific code-rate, the remedy consists of forcing to the conventional element "-1" indicating the null permutation matrix those previously forced elements of the other code-rates to carry out. In this way possible cycles at the decoder are interrupted.

| r\c | 1 | 2 | 3 | 4 | 5 | 6 | 7 | 8 | 9 | i | 79 | 80 | 81 | 82 | 83 | 84 | 85 | 86 | 87 | 88 | 89 | 90 | 91 |
|---|---|---|---|---|---|---|---|---|---|---|---|---|---|---|---|---|---|---|---|---|---|---|---|
| 1 | 66 | 72 | 78 | 84 | 90 | 96 | 102 | 0 | 5 | .... | 98 | 104 | 1 | 7 | 13 | 19 | 25 | 31 | 37 | 43 | 49 | 55 | 61 |
| 2 | 70 | 80 | 90 | 100 | 1 | 11 | 21 | 31 | 41 | .... | 87 | 97 | 107 | 8 | 18 | 28 | 38 | 48 | 58 | 68 | 78 | 88 | 98 |
| **3** | 68 | 76 | 84 | 92 | 100 | 0 | 7 | 15 | 23 | .... | 38 | 46 | **0** | 62 | 70 | 78 | 86 | 94 | 102 | 1 | 9 | 17 | **0** |
| 4 | 63 | 66 | 69 | 72 | 75 | 78 | 81 | 84 | 87 | .... | 79 | 82 | 85 | 88 | 91 | 94 | 97 | 100 | 103 | 106 | 0 | 3 | 6 |
| 5 | 72 | 84 | 96 | 0 | 11 | 23 | 35 | 47 | 59 | .... | 27 | 39 | 51 | 63 | 75 | 87 | 99 | 2 | **0** | 26 | 38 | 50 | 62 |
| **6** | 65 | 70 | 75 | 80 | 85 | 90 | 95 | 100 | 105 | .... | 19 | 24 | 29 | 34 | 39 | 44 | 49 | 54 | 59 | 64 | **0** | 74 | 61 |
| 7 | 62 | 64 | 66 | 68 | 70 | 72 | 74 | 76 | 78 | .... | 0 | 2 | 4 | 6 | 8 | 10 | 12 | 14 | 16 | 18 | 20 | | |
| **8** | 69 | 78 | 87 | 96 | 105 | 5 | 14 | 23 | 32 | .... | 8 | 17 | 26 | 35 | 44 | **0** | 62 | 71 | 80 | 89 | **49** | | |
| 9 | 61 | 62 | 63 | 64 | 65 | 66 | 67 | 68 | 69 | .... | 30 | 31 | 32 | 33 | 34 | 35 | 36 | 37 | 38 | | | | |
| **10** | 76 | 92 | 0 | 15 | 31 | 47 | 63 | 79 | 95 | .... | 16 | 32 | 48 | 64 | 80 | 96 | 3 | 19 | **37** | | | | |
| 11 | 74 | 88 | 102 | 7 | 21 | 35 | 49 | 63 | 77 | .... | 76 | 90 | 104 | 9 | 23 | 37 | | | | | | | |
| 12 | 75 | 90 | 105 | 11 | 26 | 41 | 56 | 71 | 86 | .... | 46 | 61 | 76 | 91 | 106 | 12 | | | | | | | |
| **13** | 71 | 82 | 93 | 104 | 6 | 17 | 28 | 39 | 50 | .... | 57 | 68 | 79 | 90 | 101 | **19** | | | | | | | |
| 14 | 64 | 68 | 72 | 76 | 80 | 84 | 88 | 92 | 96 | .... | 49 | 53 | 57 | | | | | | | | | | |
| 15 | 73 | 86 | 99 | 3 | 16 | 29 | 42 | 55 | 68 | .... | 106 | 10 | 23 | | | | | | | | | | |
| **16** | 67 | 74 | 81 | 88 | 95 | 102 | 0 | 7 | 14 | .... | 68 | 75 | **1** | | | | | | | | | | |

FIG. 5 – Tab. 3

EP 2 226 945 A1

**Description**

**FIELD OF THE INVENTION**

The present invention relates to fixed and mobile Broadband Wireless Access Networks implementing LDPC (Low Density Parity Check) block coding both at the channel encoder and decoder, in special way those networks compliant with the current IEEE 802.16e standardization [Ref.1], as recited in the preamble of claim 1. The invention is directed to generating optimized exponent matrixes for LDPC codes. The method is devoted to LDPC codes supporting different block sizes for each code-rate $R_j$.

According to [Ref.2], a linear block code consists of a set of fixed-length vectors called "codewords". The length of a codeword is the number of elements in the vector and is denoted by $n$. The elements of a codeword are selected from an alphabet of $q$ elements. When the alphabet consists of two symbols , 0 and 1, the code is a binary code and the elements of any codeword are called bits. There are $2^n$ possible codewords in a binary block code of length $n$. From these $2^n$ codewords, we may select $M = 2^k$ codewords ($k < n$) to form a code. Thus a block of $k$ information bits is mapped into a codeword of length $n$ selected from the set of $M = 2^k$ codewords.

As known in the art, a LDPC code is simply a block code defined by a parity-check matrix that has a low density of ones (i.e. mostly zeros). Decoding is done iteratively using Belief Propagation (BP), to say, passing of extrinsic information between codeword elements and parity check equations. LDPC codes have the following advantages: **1)** designs have approached channel capacity within 0.0045 dB; **2)** structured designs offer the great performance with faster convergence and attractive silicon solutions; **3)** structured LDPC is a viable and attractive solution with significant gains over the legacy FEC system.

It is noted that the term "exponent matrix" is an expression widely used in the LDPC block coding/decoding art to conventionally denote a matrix whose elements, also called "exponents", represent permutation matrix of the $Z_f \times Z_f$ identity matrix; the null matrix, which is conventionally expressed by the element (-1), has also $Z_f \times Z_f$ dimensions. A permutation matrix is obtained by operating a right circular shift of the identity matrix of as many positions as its exponent. Consequently, sometimes in the art the term "exponent" used for the elements of the exponent matrix may be replaced with the equivalent term "shift-size".

**BACKGROUND ART**

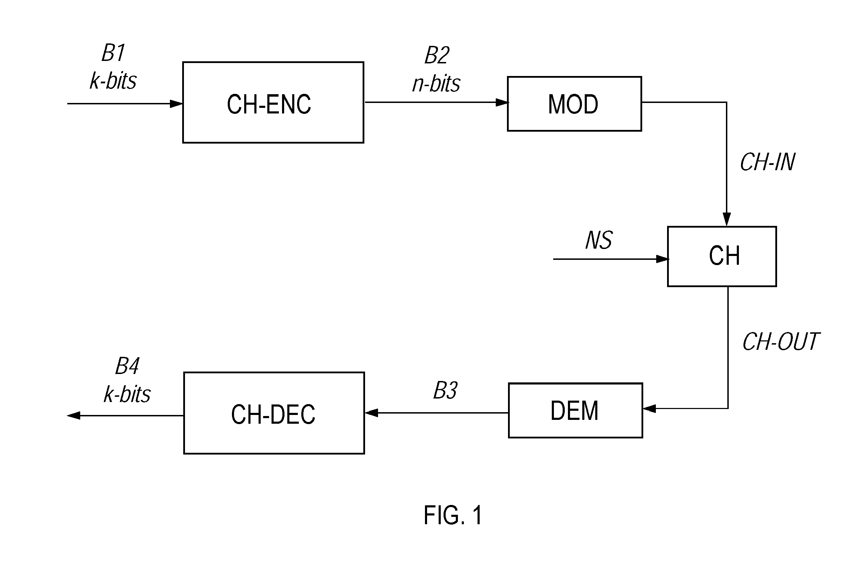

Let us consider a schematic example of a digital communication system model as the one shown in the block diagram of **Figure 1.**

The input of channel encoder CH_ENC is an information sequence $B1$ of $k$ bits to which a redundancy sequence of $r$ bits is added thereby producing an encoded sequence $B2$ of $n$ bits.

The code-rate R is defined as the ratio between the information bits number $k$ and the encoded bits number $n$, thus $R = k/n$.

Modulator MOD transforms the encoded vector $B2$ into a modulated signal vector $CH\_IN$ which is in turn transmitted through a channel CH. Since the channel CH is usually subject to noisy disturbance NS, the channel output signal $CH\_OUT$ may differ from the channel input signal $CH\_IN.$

At the receiving end, the channel output signal $CH\_OUT$ is processed by the demodulator DEM which performs the inverse operation of the modulator MOD and produces some likelihood ratio.

The channel decoder CH_DEC uses the redundancy in the received sequence $B3$ to correct the error in the information sequence of the received sequence $B3$ and produces a decoded signal $B4$ which is an information signal estimate.

State of the art encoder/decoder structures CH_ENC, CH_DEC use LDPC codes as proposed by the IEEE 802.16e Standard for Air Interface For Fixed and Mobile Broadband Wireless Access Systems [Ref.1].

LDPC codes are linear block codes. Linear block codes use a generator matrix **G** for the encoding operation and a parity-check matrix **H** for the decoding operation; nevertheless in its turn matrix **G** is most suitably obtained starting from designing the parity-check matrix $\mathbf{H}_{r \times n}$; obviously also the vice versa is possible. In conclusion, the parity-check matrix **H** can be used both for LDPC encoding and decoding.

For a block code with information sequence of $k$ bits, a codeword of $n$ bits and redundancy (parity) sequence of $r = n - k$ bits, the generator matrix **G** has $k \times n$ dimensions, and the parity-check matrix **H** has $r \times n = (n-k) \times n$ dimensions.

These two matrixes enjoy the orthogonal property, which states that for any ($k \times n$) matrix with $k$ linearly independent rows, there exists a matrix $\mathbf{H}_{r \times n}$ with $r = n - k$ linearly independent rows such that any row of $\mathbf{G}_{k \times n}$ is orthogonal to the rows of $\mathbf{H}_{r \times n}$ such that the following equation is satisfied:

$$\mathbf{G}_{k \times n} \cdot \mathbf{H}^{T}_{r \times n} = 0$$

(1)

The encoding operation is performed by means of the multiplication between the information sequence $\mathbf{U}_{1 \times k}$ and the code generator matrix $\mathbf{G}_{k \times n}$. The result, of such multiplication, is the encoded output sequence $\mathbf{V}_{1 \times n}$ as follows:

$$\mathbf{V}_{1 \times n} = \mathbf{U}_{1 \times k} \cdot \mathbf{G}_{k \times n}$$

(2)

At the receiving side, due to the orthogonal property between matrixes $\mathbf{G}_{k \times n}$ and $\mathbf{H}_{r \times n}$, the following equation should be satisfied:

$$\mathbf{H}_{r \times n} \cdot \mathbf{B}^{T}_{n \times 1} = 0$$

(3)

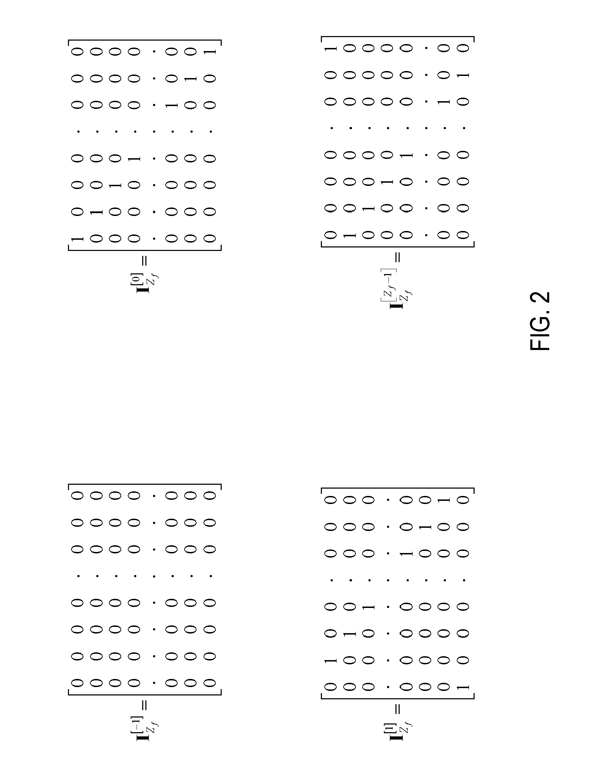

where $\mathbf{B}^{T}_{n \times 1}$ is the decoded received sequence which comprises the information signal estimate B4. If equation (3) is verified the information signal estimate B4 is correct otherwise the errors in the received sequence B3 exceed the correction capacity of the carried-out code.
The parity-check binary matrix $\mathbf{H}_{r \times n}$ is built combining in a certain manner three matrixes: the parity-check exponent matrix $\mathbf{H}_{exp}$ for a specific rate R; the "seed matrix" for that rate $R$, and the "spreading matrix" for a given spreading factor $Z_f$.
The exponent matrix is a non-binary matrix representing a block structured matrix.
The seed matrix is a binary matrix dedicated to each code-rate for masking the exponent matrix according to a compromise between performances and hardware complexity.
The spreading matrix is a square binary matrix of weight one and dimension $Z_f \times Z_f$ being $Z_f$ the desired spreading factor which in the known art is tied to the codeword length of the LDPC code.
In operation, the non-binary parity-check exponent matrix $\mathbf{H}_{exp}$ is element-by-element multiplied by the seed matrix; the result is a an opportunely masked $\mathbf{H}_{exp}$ matrix, which in turn is expanded to the parity-check binary matrix $\mathbf{H}_{r \times n}$ (called the expanded matrix $\mathbf{H}_{r \times n}$).
There are several design techniques for generating the parity-check matrix $\mathbf{H}_{r \times n}$ of a LDPC code. The most used generating technique in LDPC code design is the semi-random technique.
When realized with semi-random technique, the expanded matrix $\mathbf{H}_{r \times n}$ is constituted of two sub-matrixes: the first sub-matrix is a random matrix having $(n-k) \times k = r \times k$ size and the second one is a sub-matrix of $(n-k) \times (n-k) = r \times r$ size, conventionally called semi-deterministic sub-matrix.
It is noted that the exponent matrix is typically built with the maximum spreading factor $Z_0$ which corresponds to the maximum codeword size. However, it is possible to implement codewords of variable sizes.
When a different codeword size is desired, whose size is smaller than the maximum size, a spreading factor $Z_f$ smaller than $Z_0$ is required. In such cases, it is possible to convert the exponent matrix built with maximum spreading factor $Z_0$ into an exponent matrix having spreading factor $Z_f < Z_0$ by using some translation formulas as, for example, relation (129a) reported in IEEE 802.16e Standard [Ref.1] at page 627.
The elements of the parity-check exponent matrix $\mathbf{H}_{exp}$ comprised between 0 and $Z_f - 1$ represent permutation matrixes of the identity matrix (the one with weight equal to "1" for each row and for each column) with dimensions $Z_f \times Z_f$. The exponent indicates the size of circular shift to the right of the row elements of the identity matrix, as shown in the matrixes $\mathbf{I}^{[0]}_{Z_f}, \mathbf{I}^{[1]}_{Z_f}, \ldots, \mathbf{I}^{[Z_f-1]}_{Z_f}$ reported in **figure 2.** The exponent matrix element "-1" conventionally represents a null square matrix of size $Z_f \times Z_f$ as shown in the matrix $\mathbf{I}^{[-1]}_{Z_f}$ further reported in **figure 2**. All non-negative exponents have meaning, for example the "0" exponent corresponds to the identity matrix element. The skilled in the art easily understands that same benefits may be obtained if the cyclic shift is a cyclic shift to the left instead than a one to the right.

The parity-check exponent matrix $\mathbf{H}_{exp}$ is used in the implementation of both LDPC encoder and LDPC decoder. The IEEE 802.16e [Ref.1] shows a method for LDPC encoding (Method 2) which allows to reduce the LDPC encoder hardware complexity, on condition that the parity-check exponent matrix $\mathbf{H}_{exp}$ is opportunely built with semi-random techniques. Accordingly, three new indexes $n_b$, $r_b$, $k_b$ are derived from $n$, $r$, $k$, e.g. dividing them by $Z_f$. The two indexes $n_b$, $r_b$ respectively indicate the number of columns and the number of rows of the exponent matrix $\mathbf{H}_{exp}$, and index $k_b$ indicates the number of columns dedicated to the only structured information sequence.

As previously said, the number of columns $n_b$ of the exponent matrix $\mathbf{H}_{exp}$ is computed from the largest codeword no and the highest spreading factor $Z_0$ as follows: $n_b = n_0/z_0$. The number of rows $r_b$ of the exponent matrix $\mathbf{H}_{exp}$ depends on the code-rate $R_j$ as follows: $r_b = n_0 - k_b = n_0(1-R_j)$.

Accordingly, the $\mathbf{H}_{exp}$ matrix is split into a random sub-matrix $(r_b \times k_b)$, and a semi-deterministic sub-matrix $(r_b \times r_b)$. In its turn the semi-deterministic sub-matrix is split into a conventionally called semi-deterministic column vector $\mathbf{C}\nu$ $(r_b \times 1)$, constructed in an opportune way, and a deterministic part which includes a bidiagonal matrix as known from the art. The cited Method 2 imposes that the column vector $\mathbf{C}\nu$ has only three elements different from "-1", representing the null matrix, that the first and the last element are equal, and that only one randomly chosen element is equal to "0", representing the identity matrix.

According to [Ref.1], each code-rate R has a dedicated exponent matrix $\mathbf{H}_{exp}$ and this impacts the hardware requirements for the storage of all necessary exponent matrixes.

A proposal to reduce the hardware requirements is given by the invention disclosed in a patent application of the same Applicant mentioned at [Ref.3], which has to be considered on the basis of Article 54(3) EPC. The invention disclosed in [Ref.3] concerns a method of encoding using LDPC codes in which a multi-rate table is generated for generating exponent matrixes for LDPC codes, said LDPC codes supporting different block sizes for each code-rate $R_j$ and being implemented with semi-random technique which requires that the exponent matrixes are composed of two sub-matrixes, a random sub-matrix and a semi-deterministic sub-matrix, wherein, conditions on column vector $\mathbf{C}\nu$, the first column vector of the semi-deterministic matrix, requires that said column vector $\mathbf{C}\nu$ has only three "non-null" elements with value different from "-1", which conventionally represents a null matrix, two of said three non-null elements being the first and the last element of the column vector $\mathbf{C}\nu$ and the third non-null element being in a random position and having value "0" which represents the identity matrix; the method including the steps of:

- providing a random table having a column number $n_b$ and a row number $r_b$;
- dedicating, for each code-rate $R_j$ two rows of the random table to be processed;
- generating the multi-rate table from said random table, by processing the elements of the two dedicated rows so as to satisfy said conditions on said column vector $\mathbf{C}\nu$ as follows:

    - choosing the first dedicated row as being row $r_j$, where $r_j$ is computed as

$$r_j = n_b \cdot \left(1 - R_j\right);$$

    - choosing the second dedicated row randomly among the non-dedicated available rows between the first row and row $r_j$ excluded;
    - adding to each element of the first dedicated row $r_j$ a value so that, after a "mod" operation, the first and the last value of the column vector $\mathbf{C}\nu$ are identical;
    - adding to the each element of the second dedicated row a value so that, after a "mod" operation, the randomly chosen element in column vector $\mathbf{C}\nu$ has value "0".

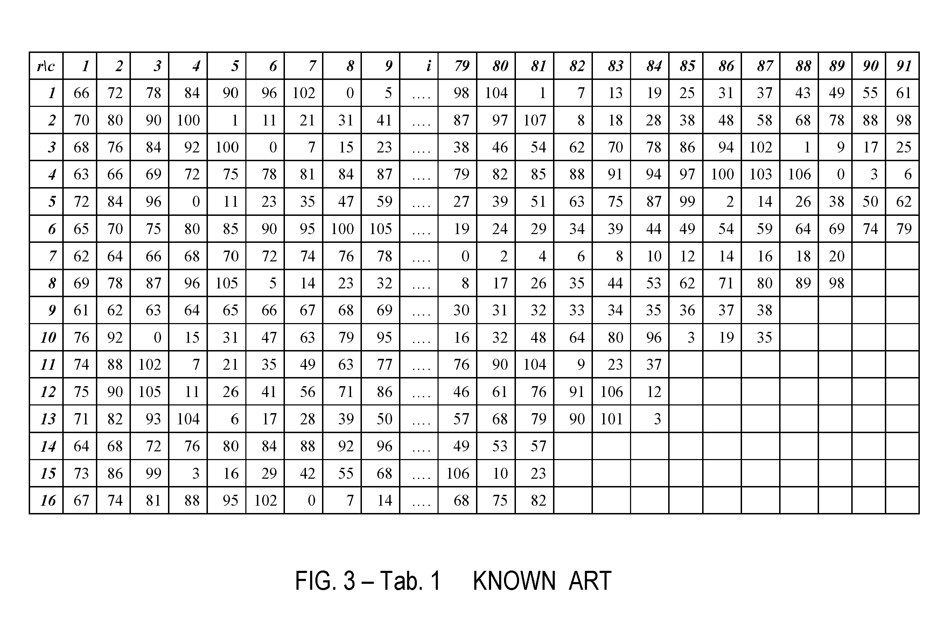

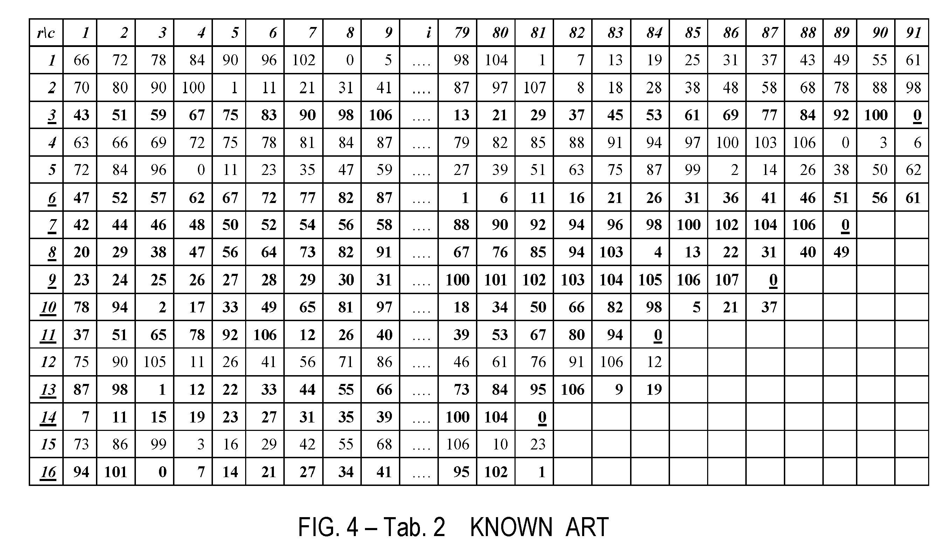

A multi-rate **Table 2** built according to the known method of above is depicted in **fig.4,** starting from an initial multi-rate **Table 1** shown in **fig.3** built according to the random rules of [Ref.1] without having care for the requirements of column vector $\mathbf{C}\nu$. The same multi-rate **Table 1** of **fig.3** will be used later on to derive the invention that will be described, enabling in such a way a direct comparison between the two methods.

With reference to **fig.3,** we see that five contiguous groups of rows in **Table 1** have decreasing row length from one group to the successive, starting from the uppermost one. Except for the top most one, each group indicates the residual rows of a component sub-table overlapping the immediately higher table with longer rows. Every sub-table is associated to a specific rate and the five rates are: $R_o = {}^{15}/_{16}$; $R_1 = {}^{11}/_{12}$; $R_2 = {}^{43}/_{48}$; $R_3 = {}^{83}/_{96}$; and $R_4 = {}^{5}/_{6}$. The last column of each overlapped table corresponds to the first column vector $\mathbf{C}\nu$ of the so-called "semi-deterministic matrix".

**Table 1** has been obtained as in the following. The number of columns $n_b$ is computed from the largest codeword length no = 10368 and the highest spreading factor $Z_0$ = 108 as follows: $n_b$ = no / $Z_0$ = 96. The columns other than vector **C**v are not considered in the table. The number of rows $r_b$ of the multi-rate table is computed from the lowest code-rate $R_4$ = 5/6 as follows: $r_b = n_b \cdot (1 - R_4) = 16$. The column index of vector **C**v is: $k_b + 1 = n_b - r_b + 1$. Every sub-table is dimensioned on the basis of its rate. Obviously, spreading factors $Z_f$ other than $Z_0$ are used for every code-rate $R_f$ in order to have LDPC codewords of different length.

When **Table 1** is processed according to the known method of [Ref.3], the result illustrated in **Table 2** is achieved, in which the processed rows are indicated in bold. The overall processed rows are 10 for a total of 864 elements.

The lowest rate $R_4$ = $^5/_6$ is not the minimum rate usually implemented, e.g. a minimum rate R = ½ is used in the method of [Ref.3]. For minimum rate $R_{min}$ =1/2 and maximum rate $R_{max}$ = 15/16, the following code-rate number with multi-rate exponent table of sizes $r_b \times n_b$ = 48x96 can be generated::

$$\text{maximum\_rate} \ \Rightarrow \ R_{\max} = \frac{15}{16} \ \Rightarrow \ H(r_{b-\max}, n_b) = H(6,96)$$
$$\text{minimum\_rate} \ \Rightarrow \ R_{\min} = \frac{1}{2} \ \Rightarrow \ H(r_{b-\min}, n_b) = H(48,96)$$
;

for a total of $\dfrac{r_{b-\max} - r_{b-\min}}{2} + 1 \ = \ 22$ rate number for LDPC\_code.

Undoubtedly the method of [Ref.3] strongly reduces the storage requirements in respect of the requirements according to the teaching of [Ref.1], but yet it undergoes the limitation of dedicating two rows of the multi-rate exponent table for every exponent matrix **H**$_{exp}$ to be derived for a specific code-rate R . Besides, the reduction in storage requirements is achieved by a moderate increasing of the processing time.

**SUMMARY OF THE INVENTION**

It is therefore an object of the present invention to overcome the above mentioned limitations and further reducing both the storage and processing requirements for achieving exponent matrixes built by different code-rates R of the channel code.

The invention achieves said object by providing a method of encoding information sequences of $k$ bits using low-density parity check code exponent matrixes, each element of which, namely the exponent, being expanded into a permutation matrix by a cyclic shift of the identity matrix with a shift-size corresponding to the value of said exponent, and every parity-check exponent matrix being composed of two contiguous sub-matrixes with the same number $r_b$ of rows and a total of $n_b$ columns, a first one being a random sub-matrix of $k_b$ columns that accounts for a block of information bits and a second one being a composite sub-matrix of $r_b$ columns that accounts for redundancy bits, the composite sub-matrix including a deterministic part of $r_b$ -1 columns and a first column vector whose elements have a value which represents the null matrix with the only exception of the first and the last element that include a same randomly selected exponent, and of a third element in a random position between the twos having a value which represents the identity matrix, the method including the following steps:

a) providing a random exponent table of $r_b$ rows and $k_b$ + 1 = $n_b$ - $r_b$ + 1 columns, being $n_b = \dfrac{n_0}{Z_0}$ determined at the longest codeword length $n_0$, the highest spreading factor $Z_0$, the number of rows $r_b = n_b \cdot (1 - R_{min})$ being determined at the lowest code-rate $R_{min}$;

b) for each code-rate $R_j$, with j positive integer, such that $R_{max} \geq R_j \geq R_{min}$, calculating a respective row number $r_j$ = $n_b \cdot (1 - R_j)$ and column number $k_j$ +1 = $n_b$ - $r_j$ + 1 of the relevant first column vector of said composite sub-matrix, then forcing the elements of random exponent table with coordinates $r_j$, $k_j$ +1 to the same value of the elements with coordinates 1, $k_j$ +1, and forcing only one of the remaining elements comprised between 2,$k_j$ +1 and $r_j$ -1, $k_j$ +1 to the exponent value (0) of the identity matrix;

c) providing an exponent matrix **H**$_{exp-j}$ for any code-rate $R_j$ including a sub-table of the exponent table as forced at the previous step, comprising the first $r_j$ rows and the first $kj$ +1 columns plus a deterministic sub-matrix for that $j$ of $r_j$ rows and $r_j$ - 1 columns, and replacing the unforced elements of the last column, except for the first one, of said sub-table with the conventional element (-1) of the null matrix, as disclosed in claim 1.

Other object of the invention is a method of decoding LDPC codewords in which the exponent matrixes associated to codewords of different rates are built with the same steps of encoding.

Additional features of the present invention which are believed to be novel are set forth with particularity in the appended claims.

Other object of the invention is a system having means operating according to the steps of the methods disclosed in the appended claims.

According to the methods of the invention and differently from the methods of [Ref.3], each row of the multi-rate exponent **Table 1** can be dedicated to more LDPC code-rates, in this way the former multiplication of the two dedicated rows by opportune permutation matrixes to obtain the right column vector is entirely prevented.

By comparison, with $R_{min}$ =1/2 and $R_{max}$ =15/16, the following code-rate number with multi-rate exponent table of sizes $r_b \times n_b$ = 48x96 can be generated:

$$\text{maximum\_rate} \Rightarrow R_{\max} = \frac{15}{16} \Rightarrow H(r_{b-\max}, n_b) = H(6, 96)$$
$$\text{minimum\_rate} \Rightarrow R_{\min} = \frac{1}{2} \Rightarrow H(r_{b-\min}, n_b) = H(48, 96)$$

for a total of $r_{b\text{-max}}$-$r_{b\text{-min}}$+1 = 43 rate_number for LDPC_code., against the only 22 of [Ref.3]. The great reduction on the processed elements (in bold) is immediately appreciable to comparatively glance at **Table 2** and **Table 3.**

A multi-rate exponent table, built with the proposed invention, is more exposed than an exponent matrix built with the known art ([Ref.1] and [Ref.3]) to cycles in the Tanner's graph, which cycles produce an LDPC code performance degradation. In fact, despite that **Table 2** is built random, nevertheless it has to respect some periodicity rules between adjacent elements on the same row and between elements of the same coordinates between adjacent rows. These rules are recommended for optimizing the decoding process, since the number of dangerous close paths on the Tanner's graph is minimized. In the method of [Ref.3] the variations introduced in the first column vector of the composite matrix with respect to the original table are reproduced on the whole elements of the row including the changed element, so that the properties of the original table are maintained.

The method in subject, deliberately contravenes said rules in **Table 3** for the precise purpose of optimizing the steps of achieving the conditions on the first column vector of the composite matrix.

According to an aspect of the present invention, the negative impact on the Tanner's graph is avoided when the exponent matrix for a certain code-rate $R_j$ is extracted from the multi-rate exponent table, forcing with the conventional element "-1" of the null permutation matrix the definite elements of the first deterministic part column vector which are dedicated to other LDPC code rates to carry-out.

### ADVANTAGES OF THE INVENTION

The proposed invention allows less expensive channel encoder/decoder equipments, since an unique model table shall be stored for deriving several exponent matrixes $\mathbf{H}_{exp}$ for variable length codewords.

The proposed invention allows fast changes of the coding scheme, since the required processing is lapsed in a short time.

The processing of the proposed invention doesn't change the block structured exponent matrix characteristics because each element maintains the characteristic of unitary weight permutation matrix.

Moreover, said processing steps do not change the characteristics of the expanded parity-check matrix of being a binary matrix with a low density of "1".

The above characteristics keep low the storage requirements and the hardware complexity of the LDPC code implementation.

### BRIEF DESCRIPTION OF THE DRAWINGS

The features of the present invention which are considered to be novel are set forth with particularity in the appended claims. The invention and its advantages may be understood with reference to the following detailed description of an embodiment thereof taken in conjunction with the accompanying drawings given for purely non-limiting explanatory purposes and wherein:

- **figure 1** shows a block diagram schematically illustrating a suitable digital communication system for implementing the present invention;

- **figure 2** shows different permutation matrixes, wherein, $\mathbf{I}_{Z_f}^{\lfloor \cdot \rfloor}$ corresponds to the null matrix and $\mathbf{I}_{Z_f}^{\lfloor \cdot \rfloor}, \mathbf{I}_{Z_f}^{\lfloor \cdot \rfloor}, \mathbf{I}_{Z_f}^{\lfloor \cdot \rfloor}$ correspond to a cyclic shift to the right of the identity matrix for a shift-size indicated by the exponent;

- **figure 3** shows a random exponent multi-rate **Table 1** of known art used as a starting point to implement the method of the present invention;

- **figure 4** shows a random exponent multi-rate **Table 2** of known art derived from Table 1 according to the method of [Ref.3];

- **figure 5** shows a random exponent multi-rate **Table 3** derived from **Table 1** according to the method of the present invention;

- **figure 6** to **10** show respective sub-tables **ST$_o$** to **ST$_4$** extracted from the multi-rate **Table 3** for the five different code-rates included, starting from the highest to the lowest rate, and further masked to the aim of the invention;

- **figure 11** shows an exponent matrix obtained by isolating the **ST$_2$** sub-table of figure 8 and completing it with a deterministic contiguous matrix.

**DETAILED DESCRIPTION OF SOME EMBODIMENTS OF THE INVENTION**

Let us consider an LDPC code with maximum code rate $R_0$ = 15/16, minimum code rate $R_4$ = 5/6, column number of the block structured parity matrix $n_b$ = 96 and the highest spreading factor $Z_0$ = 108. The LDPC codeword length $n$ is computed using the exponent matrix column number $n_b$ and the spreading factor $Z_0$, so that: $n = n_b \cdot Z_0$ = 10368. The block structured parity matrix row number $r_b$ is tied to the

LDPC code rate that we want to carry-out: $r_b = n_b(1-R)$.

Let us build, with known art the multi-rate exponent **Table 1**, which allows to implement the LDPC codes with the following rates:

$$R_0 = \frac{15}{16} = 0.9375 \quad \Rightarrow \quad H(r_{b0}, n_b) = H(6,96) \quad \Rightarrow \quad k_{b0} + 1 = n_b - r_{b0} + 1 = 91$$

$$R_1 = \frac{11}{12} = 0.9167 \quad \Rightarrow \quad H(r_{b1}, n_b) = H(8,96) \quad \Rightarrow \quad k_{b1} + 1 = n_b - r_{b1} + 1 = 89$$

$$R_2 = \frac{43}{48} = 0.8958 \quad \Rightarrow \quad H(r_{b2}, n_b) = H(10,96) \quad \Rightarrow \quad k_{b2} + 1 = n_b - r_{b2} + 1 = 87$$

$$R_3 = \frac{83}{96} = 0.8646 \quad \Rightarrow \quad H(r_{b3}, n_b) = H(13,96) \quad \Rightarrow \quad k_{b3} + 1 = n_b - r_{b3} + 1 = 84$$

$$R_4 = \frac{5}{6} = 0.8334 \quad \Rightarrow \quad H(r_{b4}, n_b) = H(16,96) \quad \Rightarrow \quad k_{b4} + 1 = n_b - r_{b4} + 1 = 81$$

in which $k_{b0}$ +1, $k_{b1}$ +1, $k_{b2}$ +1, $k_{b3}$ +1, and $k_{b4}$ +1 are, in the order, the column indexes of the first column vectors $\mathbf{C}v_0$, $\mathbf{C}v_1$, $\mathbf{C}v_2$, $\mathbf{C}v_3$, and $\mathbf{C}v_4$ of respective deterministic matrixes for code-rates $R_0$, $R_1$, $R_2$, $R_3$, and $R_4$, which matrixes will be appended successively.

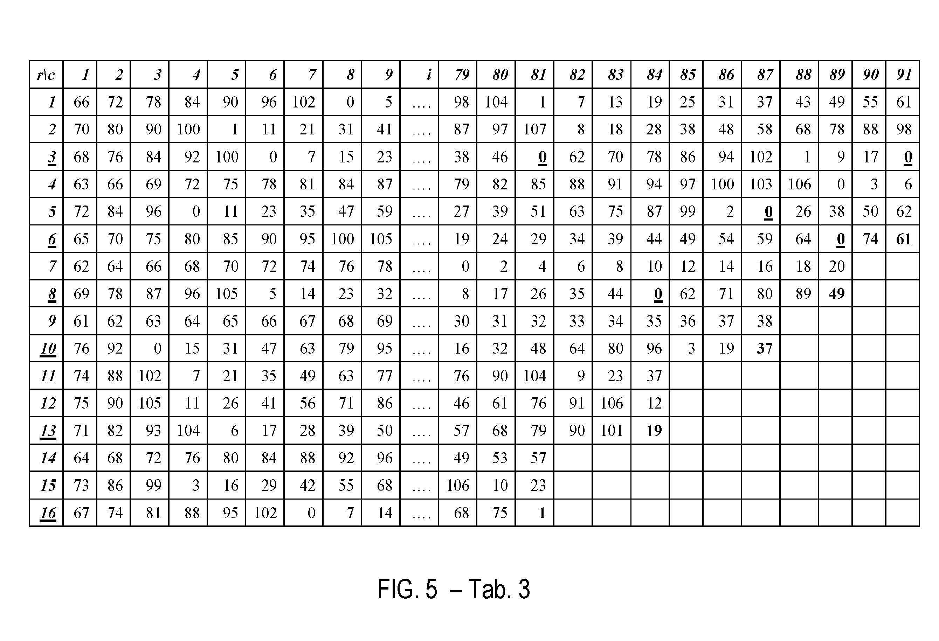

With reference to both **figures 3** and **5**, let us consider the multi-rate exponent Table **1** and mark in column vectors $\mathbf{C}v_0$, $\mathbf{C}v_1$, $\mathbf{C}v_2$, $\mathbf{C}v_3$, and $\mathbf{C}v_4$ their last element indexed by coordinates, in the order: (6,91), (8,89), (10,87), (13,84), and (16,81). The value of each element marked in **Table 1** is forced in **Table 3** to be equal to the value of the first element of the corresponding column vector, namely:

- the element (6,91) is put equal to the element (1,91),
- the element (8,89) is put equal to the element (1,89),
- the element (10,87) is put equal to the element (1,87),
- the element (13,84) is put equal to the element (1,84), and
- the element (16,81). is put equal to the element (1,81).

These forced elements are indicated in bold in **Table 3**.

Let us further mark in **Table 1** the following elements (3,91), (6,89), (5,87), (8,84), and (3,81) randomly chosen between the first and the last element (both excluded) of each column vector $\mathbf{C}v_0$, $\mathbf{C}v_1$, $\mathbf{C}v_2$, $\mathbf{C}v_3$, and $\mathbf{C}v_4$. In **Table 3** the value of each lastly marked element in **Table 1** is forced to assume the exponent value "0" indicating the identity matrix. These secondly forced elements are indicated in underlined bold in **Table 3**, in which it is possible notice that: the third row is dedicated to both code-rates $R_0$ and $R_4$; the sixth row is dedicated to both code-rates $R_0$ and $R_1$; and the eighth row is dedicated to both code-rates $R_1$ and $R_3$.

Successive steps are carried out when an exponent matrix has to be derived for a given code-rate starting from the multi-rate **Table 3.** For every code-rate a respective sub-table is needed in order to obtain the dedicated exponent matrix.

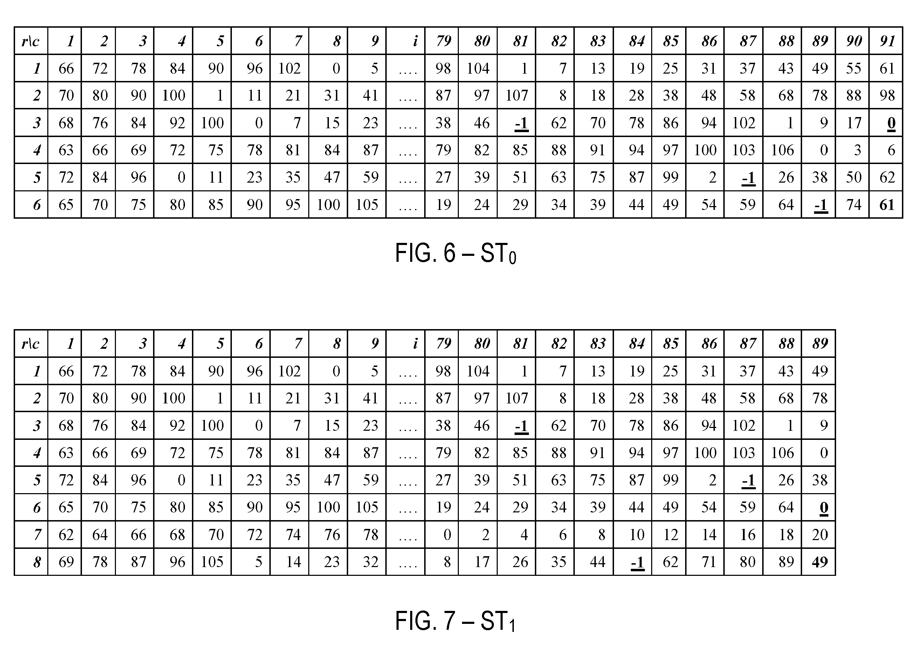

The successive **figures 6** to **10** show respective sub-tables $\mathbf{ST_o}$ to $\mathbf{ST_4}$ extracted from the multi-rate **Table 3** for the five different code-rates $R_0$ to $R_4$, included, opportunely arranged in order to change the previously forced element with the exponent value "0" of the identity matrix to the conventional element "-1" of the null matrix for implementing other code-rates.

With reference to **figure 6**, the sub-table $\mathbf{ST_o}$ relevant to the LDPC code with rate $R_0$ = 15/16 has size ($r_{b\text{-}0}$=6) $\times$($k_{b\text{-}0}$+1=91). The following three elements of **Table 3** are placed to value "-1 ":

| | | |
|---|---|---|
| (3,81) | belonging to code rate | $R_4$ = 5/6, |
| (5,87) | belonging to code rate | $R_2$ = 43/48, |
| (6,89) | belonging to code rate | $R_1$ = 11/12. |

With reference to **figure 7,** the sub-table $\mathbf{ST_1}$ relevant to the LDPC code with rate $R_1$ =11/12 has size ($r_{b\text{-}1}$ = 8)$\times$($k_{b\text{-}1}$+1=89). The following three elements of **Table 3** are placed to value "-1" of the null matrix:

| | | |
|---|---|---|
| (3,81) | belonging to code rate | $R_4$ = 5/6, |
| (8,84) | belonging to code rate | $R_3$ = 83/96, |
| (5,87) | belonging to code rate | $R_2$ = 43/48. |

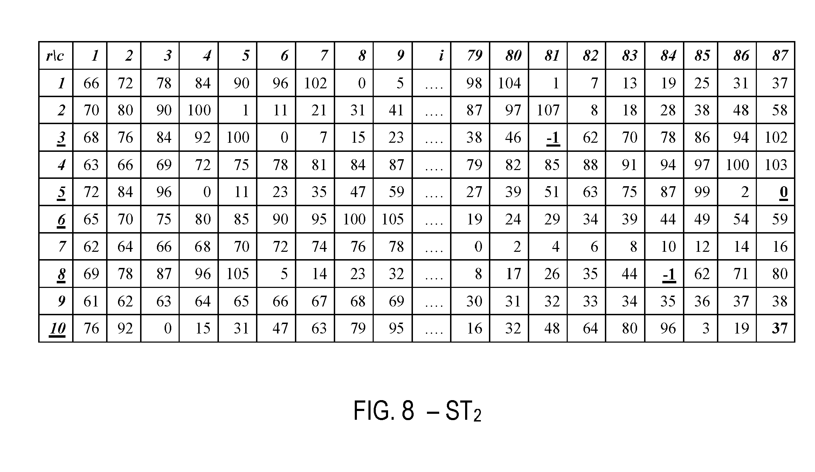

With reference to **figure 8**, the sub-table $\mathbf{ST_2}$ relevant to the LDPC code with rate $R_2$ = 43/48 has size ($r_{b\text{-}2}$=10) $\times$($k_{b\text{-}2}$+1=87). The following two elements of **Table 3** are placed to value "-1" of the null matrix:

| | | |
|---|---|---|
| (3,81) | belonging to code rate | $R_4$ = 5/6, |
| (8,84) | belonging to code rate | $R_3$ = 83/96. |

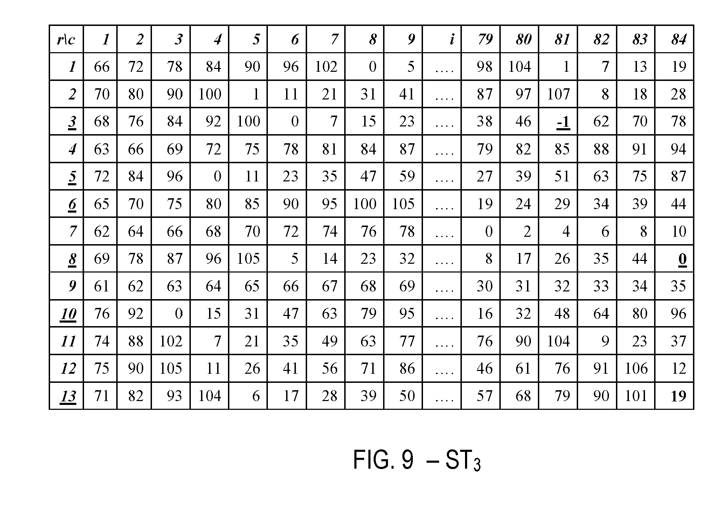

With reference to **figure 9,** the sub-table $\mathbf{ST_3}$ relevant to the LDPC code with rate $R_2$ = 83/96 has size ($r_{b\text{-}3}$=13) $\times$($k_{b\text{-}3}$+1=84). The following element of **Table 3** is placed to value "-1" of the null matrix:

| | | |
|---|---|---|
| (3,81) | belonging to code rate | $R_4$ = 5/6. |

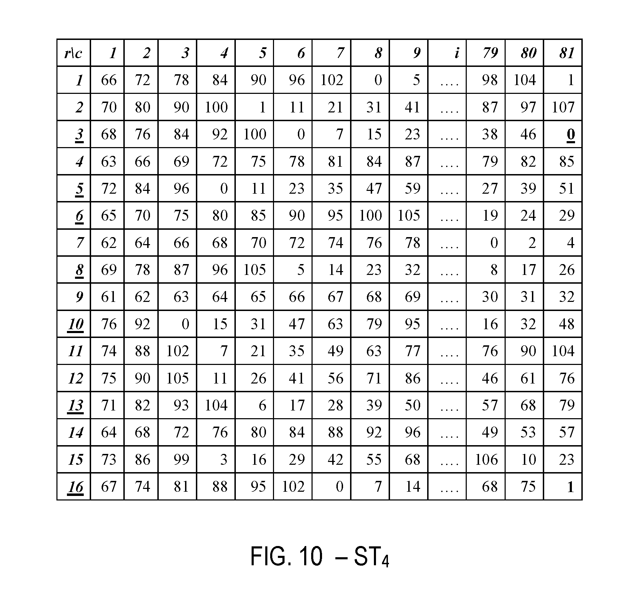

With reference to **figure 10**, the sub-table $\mathbf{ST_4}$ relevant to the LDPC code with rate $R_4$ = 5/6 has size ($r_{b\text{-}4}$=16) $\times$($k_{b\text{-}4}$+1=81) and there is not any element of **Table 3** to be changed.

## *Exemplary completion of the exponent matrix* $H_{exp\_2}$

Now let us consider the multi-rate exponent **Table 3** of **figure 5**, and let us show as to extract the random sub matrix and semi-deterministic column vector $\mathbf{C}v_{\_2}$ for implementing the exponent matrix $\mathbf{H}_{exp\_2}$ for LDPC code with rate $R_2$ = 43/48.

The exponent matrix $\mathbf{H}_{exp\_2}$ has sizes ($r_{b-2}$ = 10)$\times$($n_{b\_2}$ = 96). The corresponding sub-table $\mathbf{ST_2}$ has sizes ($r_{b-2}$ = 10)x($k_{b-2}$ + 1 = 87). Integers $k_{b-2}$ = 86 and $r_{b-2}$ = 10 correspond to the block structured information sequence and the block structured parity sequence of the LDPC codeword $n_2$ for rate $R_2$ = 43/48, respectively.

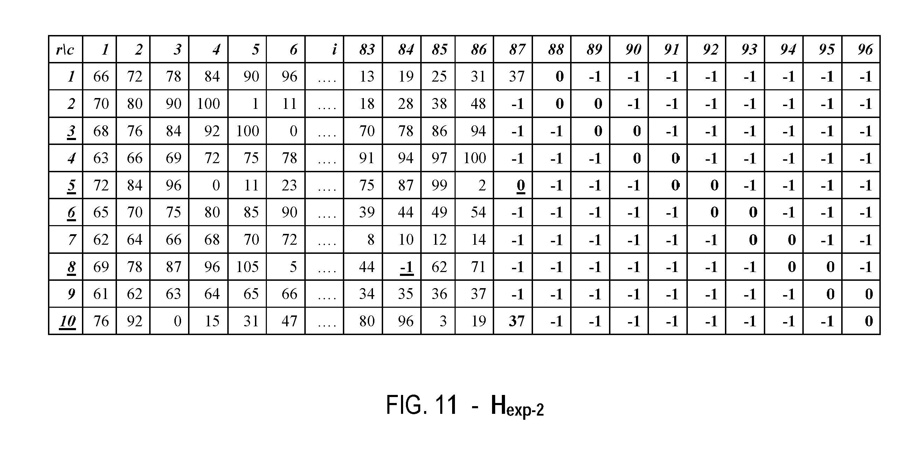

With reference to the **figures 5, 8,** and **11**, the complete exponent matrix $\mathbf{H}_{exp\_2}$ **(fig.11)** for LDPC code with rate $R_2$ = 43/48 and codeword of length $n_2$ depending on the chosen spreading factor $Z_f$ is obtained starting from the multi-rate exponent **Table 3 (fig.5)** in two alternative ways.

A first modality, preservative of the multi-length **Table 3 (fig.11)** consists of:

- copying all 870 elements of sub-table $\mathbf{ST_2}$ delimited in **Table 3** by the first 10 rows and the first 87 columns, into a processing memory reserved to the exponent matrix $\mathbf{H}_{exp\_2}$;
- forcing to value "**-1**" the elements (3,81) and (8,84) in order to obtain the sub-table $\mathbf{ST_2}$. Profitably, this operation can be postponed and conglobated in the masking of exponent matrix $\mathbf{H}_{exp\_2}$ by multiplication by a specific seed matrix;
- joining adjacently the deterministic matrix (columns 88 to 96) highlighted in bold in the exponent matrix depicted in **figure 11.**

A second modality consists of:

- eliminating from **Table 3** $r_b$-$r_{b\_2}$ = 16 - 10 = 6 rows of higher index and ($k_b$+1)-($k_{b\_2}$+1) = 91 - 87 = 4 columns of higher index;
- forcing to value "**-1**" the elements (3,81) and (8,84) in order to obtain the sub-table $\mathbf{ST_2}$ and storing it in memory. Profitably, this operation can be postponed and conglobated in the masking of exponent matrix $\mathbf{H}_{exp\_2}$ by multiplication by a specific seed matrix;
- joining adjacently the deterministic matrix (columns 88 to 96) highlighted in bold in the exponent matrix depicted in **figure 11.**

The wording "joining adjacently" shall be intended as operating onto the processing memory reserved to the exponent matrixes, and already containing sub-table $\mathbf{ST_2}$, as in the following:

- joining to the stored sub-table $\mathbf{ST_2}$ a contiguous deterministic matrix of size ($r_{b-2}\times$($r_{b\_2}$-1)) elements, in which all elements along the two left diagonals are filled with an element ("0") indicating the identity matrix, and the remaining elements are filled with an element ("**-1**") indicating the null matrix;

- replacing (whether not postponed) with an element ("**-1**") indicating the null matrix the value of all elements in the last column of the stored sub-table $\mathbf{ST_2}$ different than the first one with coordinates (1,87) and the two previously forced elements with coordinates (5,87), (10,87).

The complete exponent matrixes for other code-rates shall be derived from the respective sub-tables, accordingly.

The exponent matrix $\mathbf{H}_{exp\_2}$ opportunely multiplied (masked) by the seed matrix, and then expanded with the permutation matrixes of spreading factor $\mathbf{Z}_0$ = 108, produces the parity-check binary matrix $\mathbf{H}_{r\times n}$ which is used for implementing the LDPC code with code-rate $R$=43/48=0.8958 and codeword length $n=n_b\times Z_o$=10368.

Although the invention has been described with particular reference to a preferred embodiment, it will be evident to those skilled in the art, that the present invention is not limited thereto, but further variations and modifications may be applied without departing from the scope of the invention as defined by the annexed claims.

## References

[Ref.1] IEEE Std 802.16e - Air Interface for Fixed and Mobile Broadband Wireless Access Systems - 28 February 2006.

[Ref.2] Jon G. Proakis, "DIGITAL COMMUNICATIONS", fourth edition; published by McGraw-Hill, year 2001, ISBN 0-07-232111-3.

[Ref.3] European Patent Application EP 08425494.5 - 2223, titled: "Generating exponent matrixes for LDPC codes", filed on 22-07-2008 by Nokia Siemens Networks S.p.A.

**Used acronyms**

BP          Belief Propagation

LDPC        Low Density Parity Check Code

WiMAX       Worldwide Interoperability for Microwave Access

**Claims**

1. Method of encoding (CH-ENC) information sequences of $k$ bits using low-density parity check code exponent matrixes, each element of which, namely the exponent, being expanded into a permutation matrix $\left( \mathbf{I}_{Z_f}^{[0]}, \mathbf{I}_{Z_f}^{[1]}, \mathbf{I}_{Z_f}^{\left[ Z_f -1 \right]} \right)$ by a cyclic shift of the identity matrix $\left( \mathbf{I}_{Z_f}^{[0]} \right)$ with a shift-size corresponding to the value of said exponent, and every parity-check exponent matrix being composed of two contiguous sub-matrixes with the same number $r_b$ of rows, a first one being a random sub-matrix of $k_b$ columns that accounts for a block of information bits and a second one being a composite sub-matrix of $r_b$ columns that accounts for redundancy bits, the composite sub-matrix including a deterministic part of $r_b$ -1 columns and a first column vector whose elements have a value (-1) which represents the null matrix $\left( \mathbf{I}_{Z_f}^{[-1]} \right)$ with the only exception of the first and the last element that include a same randomly selected exponent, and of a third element in a random position between the twos having a value (0) which represents the identity matrix $\left( \mathbf{I}_{Z_f}^{[0]} \right)$,

**characterized in that** includes the following steps:

a) providing a random exponent table (Tab.1) of $r_b$ rows and $k_b$+1=$n_b$-$r_b$+1 columns, being $n_b = \dfrac{n_0}{Z_0}$ determined at the longest codeword length $n_0$, the highest spreading factor $Z_0$, the number of rows $r_b$ =$n_b \cdot$(1-$R_{\min}$) being determined at the lowest code-rate $R_{\min}$ ;

b) for each code-rate $R_j$, with j positive integer, such that $R_{\max} \geq R_j \geq R_{\min}$, calculating a respective row number $r_j = n_b \cdot$(1-$R_j$) and column number $k_j$ + 1 = $n_b$ - $r_j$ +1 of the relevant first column vector of said composite sub-matrix, then forcing the elements of random exponent table (Tab.1) with coordinates $r_j$, $k_j$ +1 to the same value of the elements with coordinates 1, $k_j$ +1, and forcing only one of the remaining elements comprised between 2,$k_j$ +1 and $r_j$ -1, $k_j$ +1 to the exponent value (0) of the identity matrix;

c) providing an exponent matrix $\mathbf{H}_{\text{exp-}j}$ for any code-rate $R_j$ including a sub-table (ST$_0$, ST$_1$, ST$_2$, ST$_3$, ST$_4$) of the exponent table as forced at the previous step (Tab.3), comprising the first $r_j$ rows and the first $k_j$ +1 columns plus a deterministic sub-matrix for that $j$ of $r_j$ rows and $r_j$-1 columns, except for the first one, and replacing the unforced elements of the last column of said sub-table with the conventional element (-1) of the null matrix.

2. Method of decoding (CH-DEC) low-density parity check codewords by means of exponent matrixes, each element of which, namely the exponent, being expanded into a permutation matrix $\left( \mathbf{I}_{Z_f}^{[0]}, \mathbf{I}_{Z_f}^{[1]}, \mathbf{I}_{Z_f}^{\left[ Z_f -1 \right]} \right)$ by a cyclic shift of

the identity matrix ($\mathbf{I}_{Z_f}^{[0]}$) with a shift-size corresponding to the value of said exponent, and every parity-check exponent matrix being composed of two contiguous sub-matrixes with the same number $r_b$ of rows, a first one being a random sub-matrix of $k_b$ columns that accounts for a block of information bits and a second one being a composite sub-matrix of $r_b$ columns that accounts for redundancy bits, the composite sub-matrix including a deterministic part of $r_b$-1 columns and a first column vector whose elements have a value (-1) which represents the null matrix ($\mathbf{I}_{Z_f}^{[-1]}$) with the only exception of the first and the last element that include a same randomly selected exponent, and of a third element in a random position between the twos having a value (0) which represents the identity matrix ($\mathbf{I}_{Z_f}^{[0]}$), **characterized in that** includes the following steps:

a) providing a random exponent table (Tab.1) of $r_b$ rows and $k_b$+1=$n_b$-$r_b$+1 columns, being $n_b = \dfrac{n_0}{Z_0}$ determined at the longest codeword length $n_0$, the highest spreading factor $Z_0$' the number of rows $r_b$ =$n_b$·(1-$R_{min}$) being determined at the lowest code-rate $R_{min}$;

b) for each code-rate $R_j$, with j positive integer, such that $R_{max} \geq R_j \geq R_{min}$, calculating a respective row number $r_j$ =$n_b$·(1-$R_j$) and column number $k_j$+1=$n_b$-$r_j$+1 of the relevant first column vector of said composite sub-matrix, then forcing the elements of random exponent table (Tab.1) with coordinates $r_j$, $k_j$ +1 to the same value of the elements with coordinates 1, $k_j$ +1, and forcing only one of the remaining elements comprised between 2, $k_j$ +1 and $r_j$ -1, $k_j$ +1 to the exponent value (0) of the identity matrix;

c) providing an exponent matrix $\mathbf{H}_{exp-j}$ for any code-rate $R_j$ including a sub-table (ST$_0$, ST$_1$, ST$_2$, ST$_3$, ST$_4$) of the exponent table as forced at the previous step (Tab.3), comprising the first $r_j$ rows and the first $k_j$ +1 columns plus a deterministic sub-matrix for that $j$ of $r_j$ rows and $r_j$ -1 columns, and replacing the unforced elements of the last column, except fro the first one, of said sub-table with the conventional element (-1) of the null matrix.

3. The method of claim 1 or 2, **characterized in that** further includes the step of forcing the conventional element (-1) of the null permutation matrix ($\mathbf{I}_{Z_f}^{[-1]}$) into those elements of the last column in any sub-table (ST$_0$, ST$_1$, ST$_2$, ST$_3$, ST$_4$) of a given code-rate $R_j$ extracted at step c) from the exponent table (Tab.3) which are dedicated to other LDPC code-rates to carry out.

4. A system (FIG.1) having means (CH-ENC, CH-DEC) for performing the steps of the method according to any claim from 1 to 3.

FIG. 1

$$\mathbf{I}_{Z_f}^{[0]} = \begin{bmatrix} 0 & 0 & 0 & 0 & \cdot & 0 & 0 & 1 \\ 0 & 0 & 0 & 0 & \cdot & 0 & 1 & 0 \\ 0 & 0 & 0 & 0 & \cdot & 1 & 0 & 0 \\ \cdot & \cdot & \cdot & \cdot & \cdot & \cdot & \cdot & \cdot \\ 0 & 0 & 0 & 1 & \cdot & 0 & 0 & 0 \\ 0 & 0 & 1 & 0 & \cdot & 0 & 0 & 0 \\ 0 & 1 & 0 & 0 & \cdot & 0 & 0 & 0 \\ 1 & 0 & 0 & 0 & \cdot & 0 & 0 & 0 \end{bmatrix}$$

$$\mathbf{I}_{Z_f}^{[Z_f-1]} = \begin{bmatrix} 1 & 0 & 0 & 0 & 0 & \cdot & 0 & 0 \\ 0 & 0 & 0 & 0 & 0 & \cdot & 0 & 1 \\ 0 & 0 & 0 & 0 & 0 & \cdot & 1 & 0 \\ \cdot & \cdot & \cdot & \cdot & \cdot & \cdot & \cdot & \cdot \\ 0 & 0 & 0 & 0 & 1 & \cdot & 0 & 0 \\ 0 & 0 & 0 & 1 & 0 & \cdot & 0 & 0 \\ 0 & 0 & 1 & 0 & 0 & \cdot & 0 & 0 \\ 0 & 1 & 0 & 0 & 0 & \cdot & 0 & 0 \end{bmatrix}$$

$$\mathbf{I}_{Z_f}^{[-1]} = \begin{bmatrix} 0 & 0 & 0 & 0 & \cdot & 0 & 0 & 0 \\ 0 & 0 & 0 & 0 & \cdot & 0 & 0 & 0 \\ 0 & 0 & 0 & 0 & \cdot & 0 & 0 & 0 \\ \cdot & \cdot & \cdot & \cdot & \cdot & \cdot & \cdot & \cdot \\ 0 & 0 & 0 & 0 & \cdot & 0 & 0 & 0 \\ 0 & 0 & 0 & 0 & \cdot & 0 & 0 & 0 \\ 0 & 0 & 0 & 0 & \cdot & 0 & 0 & 0 \\ 0 & 0 & 0 & 0 & \cdot & 0 & 0 & 0 \end{bmatrix}$$

$$\mathbf{I}_{Z_f}^{[1]} = \begin{bmatrix} 0 & 0 & 0 & \cdot & 0 & 0 & 1 & 0 \\ 0 & 0 & 0 & \cdot & 0 & 1 & 0 & 0 \\ 0 & 0 & 0 & \cdot & 1 & 0 & 0 & 0 \\ \cdot & \cdot & \cdot & \cdot & \cdot & \cdot & \cdot & \cdot \\ 0 & 0 & 1 & \cdot & 0 & 0 & 0 & 0 \\ 0 & 1 & 0 & \cdot & 0 & 0 & 0 & 0 \\ 1 & 0 & 0 & \cdot & 0 & 0 & 0 & 0 \\ 0 & 0 & 0 & \cdot & 0 & 0 & 0 & 1 \end{bmatrix}$$

FIG. 2

| r\c | 1 | 2 | 3 | 4 | 5 | 6 | 7 | 8 | 9 | i | 79 | 80 | 81 | 82 | 83 | 84 | 85 | 86 | 87 | 88 | 89 | 90 | 91 |
|---|---|---|---|---|---|---|---|---|---|---|---|---|---|---|---|---|---|---|---|---|---|---|---|
| 1 | 66 | 72 | 78 | 84 | 90 | 96 | 102 | 0 | 5 | ... | 98 | 104 | 1 | 7 | 13 | 19 | 25 | 31 | 37 | 43 | 49 | 55 | 61 |
| 2 | 70 | 80 | 90 | 100 | 1 | 11 | 21 | 31 | 41 | ... | 87 | 97 | 107 | 8 | 18 | 28 | 38 | 48 | 58 | 68 | 78 | 88 | 98 |
| 3 | 68 | 76 | 84 | 92 | 100 | 0 | 7 | 15 | 23 | ... | 38 | 46 | 54 | 62 | 70 | 78 | 86 | 94 | 102 | 1 | 9 | 17 | 25 |
| 4 | 63 | 66 | 69 | 72 | 75 | 78 | 81 | 84 | 87 | ... | 79 | 82 | 85 | 88 | 91 | 94 | 97 | 100 | 103 | 106 | 0 | 3 | 6 |
| 5 | 72 | 84 | 96 | 0 | 11 | 23 | 35 | 47 | 59 | ... | 27 | 39 | 51 | 63 | 75 | 87 | 99 | 2 | 14 | 26 | 38 | 50 | 62 |
| 6 | 65 | 70 | 75 | 80 | 85 | 90 | 95 | 100 | 105 | ... | 19 | 24 | 29 | 34 | 39 | 44 | 49 | 54 | 59 | 64 | 69 | 74 | 79 |
| 7 | 62 | 64 | 66 | 68 | 70 | 72 | 74 | 76 | 78 | ... | 0 | 2 | 4 | 6 | 8 | 10 | 12 | 14 | 16 | 18 | 20 | | |
| 8 | 69 | 78 | 87 | 96 | 105 | 5 | 14 | 23 | 32 | ... | 8 | 17 | 26 | 35 | 44 | 53 | 62 | 71 | 80 | 89 | 98 | | |
| 9 | 61 | 62 | 63 | 64 | 65 | 66 | 67 | 68 | 69 | ... | 30 | 31 | 32 | 33 | 34 | 35 | 36 | 37 | 38 | | | | |
| 10 | 76 | 92 | 0 | 15 | 31 | 47 | 63 | 79 | 95 | ... | 16 | 32 | 48 | 64 | 80 | 96 | 3 | 19 | 35 | | | | |
| 11 | 74 | 88 | 102 | 7 | 21 | 35 | 49 | 63 | 77 | ... | 76 | 90 | 104 | 9 | 23 | 37 | | | | | | | |
| 12 | 75 | 90 | 105 | 11 | 26 | 41 | 56 | 71 | 86 | ... | 46 | 61 | 76 | 91 | 106 | 12 | | | | | | | |
| 13 | 71 | 82 | 93 | 104 | 6 | 17 | 28 | 39 | 50 | ... | 57 | 68 | 79 | 90 | 101 | 3 | | | | | | | |
| 14 | 64 | 68 | 72 | 76 | 80 | 84 | 88 | 92 | 96 | ... | 49 | 53 | 57 | | | | | | | | | | |
| 15 | 73 | 86 | 99 | 3 | 16 | 29 | 42 | 55 | 68 | ... | 106 | 10 | 23 | | | | | | | | | | |
| 16 | 67 | 74 | 81 | 88 | 95 | 102 | 0 | 7 | 14 | ... | 68 | 75 | 82 | | | | | | | | | | |

FIG. 3 – Tab. 1   KNOWN ART

14

| r\c | 1 | 2 | 3 | 4 | 5 | 6 | 7 | 8 | 9 | i | 79 | 80 | 81 | 82 | 83 | 84 | 85 | 86 | 87 | 88 | 89 | 90 | 91 |
|---|---|---|---|---|---|---|---|---|---|---|---|---|---|---|---|---|---|---|---|---|---|---|---|
| 1 | 66 | 72 | 78 | 84 | 90 | 96 | 102 | 0 | 5 | .... | 98 | 104 | 1 | 7 | 13 | 19 | 25 | 31 | 37 | 43 | 49 | 55 | 61 |
| 2 | 70 | 80 | 90 | 100 | 1 | 11 | 21 | 31 | 41 | .... | 87 | 97 | 107 | 8 | 18 | 28 | 38 | 48 | 58 | 68 | 78 | 88 | 98 |
| 3 | 43 | 51 | 59 | 67 | 75 | 83 | 90 | 98 | 106 | .... | 13 | 21 | 29 | 37 | 45 | 53 | 61 | 69 | 77 | 84 | 92 | 100 | 0 |
| 4 | 63 | 66 | 69 | 72 | 75 | 78 | 81 | 84 | 87 | .... | 79 | 82 | 85 | 88 | 91 | 94 | 97 | 100 | 103 | 106 | 0 | 3 | 6 |
| 5 | 72 | 84 | 96 | 0 | 11 | 23 | 35 | 47 | 59 | .... | 27 | 39 | 51 | 63 | 75 | 87 | 99 | 2 | 14 | 26 | 38 | 50 | 62 |
| 6 | 47 | 52 | 57 | 62 | 67 | 72 | 77 | 82 | 87 | .... | 1 | 6 | 11 | 16 | 21 | 26 | 31 | 36 | 41 | 46 | 51 | 56 | 61 |
| 7 | 42 | 44 | 46 | 48 | 50 | 52 | 54 | 56 | 58 | .... | 88 | 90 | 92 | 94 | 96 | 98 | 100 | 102 | 104 | 106 | 0 | | |
| 8 | 20 | 29 | 38 | 47 | 56 | 64 | 73 | 82 | 91 | .... | 67 | 76 | 85 | 94 | 103 | 4 | 13 | 22 | 31 | 40 | 49 | | |
| 9 | 23 | 24 | 25 | 26 | 27 | 28 | 29 | 30 | 31 | .... | 100 | 101 | 102 | 103 | 104 | 105 | 106 | 107 | 0 | | | | |
| 10 | 78 | 94 | 2 | 17 | 33 | 49 | 65 | 81 | 97 | .... | 18 | 34 | 50 | 66 | 82 | 98 | 5 | 21 | 37 | | | | |
| 11 | 37 | 51 | 65 | 78 | 92 | 106 | 12 | 26 | 40 | .... | 39 | 53 | 67 | 80 | 94 | 0 | | | | | | | |
| 12 | 75 | 90 | 105 | 11 | 26 | 41 | 56 | 71 | 86 | .... | 46 | 61 | 76 | 91 | 106 | 12 | | | | | | | |
| 13 | 87 | 98 | 1 | 12 | 22 | 33 | 44 | 55 | 66 | .... | 73 | 84 | 95 | 106 | 9 | 19 | | | | | | | |
| 14 | 7 | 11 | 15 | 19 | 23 | 27 | 31 | 35 | 39 | .... | 100 | 104 | 0 | | | | | | | | | | |
| 15 | 73 | 86 | 99 | 3 | 16 | 29 | 42 | 55 | 68 | .... | 106 | 10 | 23 | | | | | | | | | | |
| 16 | 94 | 101 | 0 | 7 | 14 | 21 | 27 | 34 | 41 | .... | 95 | 102 | 1 | | | | | | | | | | |

FIG. 4 – Tab. 2   KNOWN  ART

| r\c | 1 | 2 | 3 | 4 | 5 | 6 | 7 | 8 | 9 | i | 79 | 80 | 81 | 82 | 83 | 84 | 85 | 86 | 87 | 88 | 89 | 90 | 91 |
|---|---|---|---|---|---|---|---|---|---|---|---|---|---|---|---|---|---|---|---|---|---|---|---|
| 1 | 66 | 72 | 78 | 84 | 90 | 96 | 102 | 0 | 5 | .... | 98 | 104 | 1 | 7 | 13 | 19 | 25 | 31 | 37 | 43 | 49 | 55 | 61 |
| 2 | 70 | 80 | 90 | 100 | 1 | 11 | 21 | 31 | 41 | .... | 87 | 97 | 107 | 8 | 18 | 28 | 38 | 48 | 58 | 68 | 78 | 88 | 98 |
| **3** | 68 | 76 | 84 | 92 | 100 | 0 | 7 | 15 | 23 | .... | 38 | 46 | **0** | 62 | 70 | 78 | 86 | 94 | 102 | 1 | 9 | 17 | **0** |
| 4 | 63 | 66 | 69 | 72 | 75 | 78 | 81 | 84 | 87 | .... | 79 | 82 | 85 | 88 | 91 | 94 | 97 | 100 | 103 | 106 | 0 | 3 | 6 |
| 5 | 72 | 84 | 96 | 0 | 11 | 23 | 35 | 47 | 59 | .... | 27 | 39 | 51 | 63 | 75 | 87 | 99 | 2 | **0** | 26 | 38 | 50 | 62 |
| **6** | 65 | 70 | 75 | 80 | 85 | 90 | 95 | 100 | 105 | .... | 19 | 24 | 29 | 34 | 39 | 44 | 49 | 54 | 59 | 64 | **0** | 74 | **61** |
| 7 | 62 | 64 | 66 | 68 | 70 | 72 | 74 | 76 | 78 | .... | 0 | 2 | 4 | 6 | 8 | 10 | 12 | 14 | 16 | 18 | 20 | | |
| **8** | 69 | 78 | 87 | 96 | 105 | 5 | 14 | 23 | 32 | .... | 8 | 17 | 26 | 35 | 44 | **0** | 62 | 71 | 80 | 89 | **49** | | |
| 9 | 61 | 62 | 63 | 64 | 65 | 66 | 67 | 68 | 69 | .... | 30 | 31 | 32 | 33 | 34 | 35 | 36 | 37 | 38 | | | | |
| **10** | 76 | 92 | 0 | 15 | 31 | 47 | 63 | 79 | 95 | .... | 16 | 32 | 48 | 64 | 80 | 96 | 3 | 19 | **37** | | | | |
| 11 | 74 | 88 | 102 | 7 | 21 | 35 | 49 | 63 | 77 | .... | 76 | 90 | 104 | 9 | 23 | 37 | | | | | | | |
| 12 | 75 | 90 | 105 | 11 | 26 | 41 | 56 | 71 | 86 | .... | 46 | 61 | 76 | 91 | 106 | 12 | | | | | | | |
| **13** | 71 | 82 | 93 | 104 | 6 | 17 | 28 | 39 | 50 | .... | 57 | 68 | 79 | 90 | 101 | **19** | | | | | | | |
| 14 | 64 | 68 | 72 | 76 | 80 | 84 | 88 | 92 | 96 | .... | 49 | 53 | 57 | | | | | | | | | | |
| 15 | 73 | 86 | 99 | 3 | 16 | 29 | 42 | 55 | 68 | .... | 106 | 10 | 23 | | | | | | | | | | |
| **16** | 67 | 74 | 81 | 88 | 95 | 102 | 0 | 7 | 14 | .... | 68 | 75 | **1** | | | | | | | | | | |

FIG. 5 – Tab. 3

| r\c | 1 | 2 | 3 | 4 | 5 | 6 | 7 | 8 | 9 | i .... | 79 | 80 | 81 | 82 | 83 | 84 | 85 | 86 | 87 | 88 | 89 | 90 | 91 |
|---|---|---|---|---|---|---|---|---|---|---|---|---|---|---|---|---|---|---|---|---|---|---|---|
| 1 | 66 | 72 | 78 | 84 | 90 | 96 | 102 | 0 | 5 | .... | 98 | 104 | 1 | 7 | 13 | 19 | 25 | 31 | 37 | 43 | 49 | 55 | 61 |
| 2 | 70 | 80 | 90 | 100 | 1 | 11 | 21 | 31 | 41 | .... | 87 | 97 | 107 | 8 | 18 | 28 | 38 | 48 | 58 | 68 | 78 | 88 | 98 |
| 3 | 68 | 76 | 84 | 92 | 100 | 0 | 7 | 15 | 23 | .... | 38 | 46 | −1 | 62 | 70 | 78 | 86 | 94 | 102 | 1 | 9 | 17 | **0** |
| 4 | 63 | 66 | 69 | 72 | 75 | 78 | 81 | 84 | 87 | .... | 79 | 82 | 85 | 88 | 91 | 94 | 97 | 100 | 103 | 106 | 0 | 3 | 6 |
| 5 | 72 | 84 | 96 | 0 | 11 | 23 | 35 | 47 | 59 | .... | 27 | 39 | 51 | 63 | 75 | 87 | 99 | 2 | −1 | 26 | 38 | 50 | 62 |
| 6 | 65 | 70 | 75 | 80 | 85 | 90 | 95 | 100 | 105 | .... | 19 | 24 | 29 | 34 | 39 | 44 | 49 | 54 | 59 | 64 | **−1** | 74 | 61 |

FIG. 6 – $ST_0$

| r\c | 1 | 2 | 3 | 4 | 5 | 6 | 7 | 8 | 9 | i .... | 79 | 80 | 81 | 82 | 83 | 84 | 85 | 86 | 87 | 88 | 89 |
|---|---|---|---|---|---|---|---|---|---|---|---|---|---|---|---|---|---|---|---|---|---|
| 1 | 66 | 72 | 78 | 84 | 90 | 96 | 102 | 0 | 5 | .... | 98 | 104 | 1 | 7 | 13 | 19 | 25 | 31 | 37 | 43 | 49 |
| 2 | 70 | 80 | 90 | 100 | 1 | 11 | 21 | 31 | 41 | .... | 87 | 97 | 107 | 8 | 18 | 28 | 38 | 48 | 58 | 68 | 78 |
| 3 | 68 | 76 | 84 | 92 | 100 | 0 | 7 | 15 | 23 | .... | 38 | 46 | −1 | 62 | 70 | 78 | 86 | 94 | 102 | 1 | 9 |
| 4 | 63 | 66 | 69 | 72 | 75 | 78 | 81 | 84 | 87 | .... | 79 | 82 | 85 | 88 | 91 | 94 | 97 | 100 | 103 | 106 | 0 |
| 5 | 72 | 84 | 96 | 0 | 11 | 23 | 35 | 47 | 59 | .... | 27 | 39 | 51 | 63 | 75 | 87 | 99 | 2 | −1 | 26 | 38 |
| 6 | 65 | 70 | 75 | 80 | 85 | 90 | 95 | 100 | 105 | .... | 19 | 24 | 29 | 34 | 39 | 44 | 49 | 54 | 59 | 64 | **0** |
| 7 | 62 | 64 | 66 | 68 | 70 | 72 | 74 | 76 | 78 | .... | 0 | 2 | 4 | 6 | 8 | 10 | 12 | 14 | 16 | 18 | 20 |
| 8 | 69 | 78 | 87 | 96 | 105 | 5 | 14 | 23 | 32 | .... | 8 | 17 | 26 | 35 | 44 | **−1** | 62 | 71 | 80 | 89 | **49** |

FIG. 7 – $ST_1$

| r\c | 1 | 2 | 3 | 4 | 5 | 6 | 7 | 8 | 9 | i | 79 | 80 | 81 | 82 | 83 | 84 | 85 | 86 | 87 |
|---|---|---|---|---|---|---|---|---|---|---|---|---|---|---|---|---|---|---|---|
| 1 | 66 | 72 | 78 | 84 | 90 | 96 | 102 | 0 | 5 | .... | 98 | 104 | 1 | 7 | 13 | 19 | 25 | 31 | 37 |
| 2 | 70 | 80 | 90 | 100 | 1 | 11 | 21 | 31 | 41 | .... | 87 | 97 | 107 | 8 | 18 | 28 | 38 | 48 | 58 |
| 3 | 68 | 76 | 84 | 92 | 100 | 0 | 7 | 15 | 23 | .... | 38 | 46 | -1 | 62 | 70 | 78 | 86 | 94 | 102 |
| 4 | 63 | 66 | 69 | 72 | 75 | 78 | 81 | 84 | 87 | .... | 79 | 82 | 85 | 88 | 91 | 94 | 97 | 100 | 103 |
| 5 | 72 | 84 | 96 | 0 | 11 | 23 | 35 | 47 | 59 | .... | 27 | 39 | 51 | 63 | 75 | 87 | 99 | 2 | 0 |
| 6 | 65 | 70 | 75 | 80 | 85 | 90 | 95 | 100 | 105 | .... | 19 | 24 | 29 | 34 | 39 | 44 | 49 | 54 | 59 |
| 7 | 62 | 64 | 66 | 68 | 70 | 72 | 74 | 76 | 78 | .... | 0 | 2 | 4 | 6 | 8 | 10 | 12 | 14 | 16 |
| 8 | 69 | 78 | 87 | 96 | 105 | 5 | 14 | 23 | 32 | .... | 8 | 17 | 26 | 35 | 44 | -1 | 62 | 71 | 80 |
| 9 | 61 | 62 | 63 | 64 | 65 | 66 | 67 | 68 | 69 | .... | 30 | 31 | 32 | 33 | 34 | 35 | 36 | 37 | 38 |
| 10 | 76 | 92 | 0 | 15 | 31 | 47 | 63 | 79 | 95 | .... | 16 | 32 | 48 | 64 | 80 | 96 | 3 | 19 | 37 |

$$\text{FIG. 8 } - \text{ST}_2$$

| r\c | 1 | 2 | 3 | 4 | 5 | 6 | 7 | 8 | 9 | i | 79 | 80 | 81 | 82 | 83 | 84 |
|---|---|---|---|---|---|---|---|---|---|---|---|---|---|---|---|---|
| 1 | 66 | 72 | 78 | 84 | 90 | 96 | 102 | 0 | 5 | .... | 98 | 104 | 1 | 7 | 13 | 19 |
| 2 | 70 | 80 | 90 | 100 | 1 | 11 | 21 | 31 | 41 | .... | 87 | 97 | 107 | 8 | 18 | 28 |
| 3 | 68 | 76 | 84 | 92 | 100 | 0 | 7 | 15 | 23 | .... | 38 | 46 | -1 | 62 | 70 | 78 |
| 4 | 63 | 66 | 69 | 72 | 75 | 78 | 81 | 84 | 87 | .... | 79 | 82 | 85 | 88 | 91 | 94 |
| 5 | 72 | 84 | 96 | 0 | 11 | 23 | 35 | 47 | 59 | .... | 27 | 39 | 51 | 63 | 75 | 87 |
| 6 | 65 | 70 | 75 | 80 | 85 | 90 | 95 | 100 | 105 | .... | 19 | 24 | 29 | 34 | 39 | 44 |
| 7 | 62 | 64 | 66 | 68 | 70 | 72 | 74 | 76 | 78 | .... | 0 | 2 | 4 | 6 | 8 | 10 |
| 8 | 69 | 78 | 87 | 96 | 105 | 5 | 14 | 23 | 32 | .... | 8 | 17 | 26 | 35 | 44 | 0 |
| 9 | 61 | 62 | 63 | 64 | 65 | 66 | 67 | 68 | 69 | .... | 30 | 31 | 32 | 33 | 34 | 35 |
| 10 | 76 | 92 | 0 | 15 | 31 | 47 | 63 | 79 | 95 | .... | 16 | 32 | 48 | 64 | 80 | 96 |
| 11 | 74 | 88 | 102 | 7 | 21 | 35 | 49 | 63 | 77 | .... | 76 | 90 | 104 | 9 | 23 | 37 |
| 12 | 75 | 90 | 105 | 11 | 26 | 41 | 56 | 71 | 86 | .... | 46 | 61 | 76 | 91 | 106 | 12 |
| 13 | 71 | 82 | 93 | 104 | 6 | 17 | 28 | 39 | 50 | .... | 57 | 68 | 79 | 90 | 101 | 19 |

FIG. 9 – ST$_3$

EP 2 226 945 A1

| r\c | 1 | 2 | 3 | 4 | 5 | 6 | 7 | 8 | 9 | i | 79 | 80 | 81 |
|---|---|---|---|---|---|---|---|---|---|---|---|---|---|
| 1 | 66 | 72 | 78 | 84 | 90 | 96 | 102 | 0 | 5 | .... | 98 | 104 | 1 |
| 2 | 70 | 80 | 90 | 100 | 1 | 11 | 21 | 31 | 41 | .... | 87 | 97 | 107 |
| 3 | 68 | 76 | 84 | 92 | 100 | 0 | 7 | 15 | 23 | .... | 38 | 46 | **0** |
| 4 | 63 | 66 | 69 | 72 | 75 | 78 | 81 | 84 | 87 | .... | 79 | 82 | 85 |
| 5 | 72 | 84 | 96 | 0 | 11 | 23 | 35 | 47 | 59 | .... | 27 | 39 | 51 |
| 6 | 65 | 70 | 75 | 80 | 85 | 90 | 95 | 100 | 105 | .... | 19 | 24 | 29 |
| 7 | 62 | 64 | 66 | 68 | 70 | 72 | 74 | 76 | 78 | .... | 0 | 2 | 4 |
| 8 | 69 | 78 | 87 | 96 | 105 | 5 | 14 | 23 | 32 | .... | 8 | 17 | 26 |
| 9 | 61 | 62 | 63 | 64 | 65 | 66 | 67 | 68 | 69 | .... | 30 | 31 | 32 |
| 10 | 76 | 92 | 0 | 15 | 31 | 47 | 63 | 79 | 95 | .... | 16 | 32 | 48 |
| 11 | 74 | 88 | 102 | 7 | 21 | 35 | 49 | 63 | 77 | .... | 76 | 90 | 104 |
| 12 | 75 | 90 | 105 | 11 | 26 | 41 | 56 | 71 | 86 | .... | 46 | 61 | 76 |
| 13 | 71 | 82 | 93 | 104 | 6 | 17 | 28 | 39 | 50 | .... | 57 | 68 | 79 |
| 14 | 64 | 68 | 72 | 76 | 80 | 84 | 88 | 92 | 96 | .... | 49 | 53 | 57 |
| 15 | 73 | 86 | 99 | 3 | 16 | 29 | 42 | 55 | 68 | .... | 106 | 10 | 23 |
| 16 | 67 | 74 | 81 | 88 | 95 | 102 | 0 | 7 | 14 | .... | 68 | 75 | **1** |

FIG. 10 – ST$_4$

| r\c | 1 | 2 | 3 | 4 | 5 | 6 | i | 83 | 84 | 85 | 86 | 87 | 88 | 89 | 90 | 91 | 92 | 93 | 94 | 95 | 96 |
|---|---|---|---|---|---|---|---|---|---|---|---|---|---|---|---|---|---|---|---|---|---|
| 1 | 66 | 72 | 78 | 84 | 90 | 96 | .... | 13 | 19 | 25 | 31 | 37 | **0** | -1 | -1 | -1 | -1 | -1 | -1 | -1 | -1 |
| 2 | 70 | 80 | 90 | 100 | 1 | 11 | .... | 18 | 28 | 38 | 48 | **-1** | **0** | **0** | -1 | -1 | -1 | -1 | -1 | -1 | -1 |
| 3 | 68 | 76 | 84 | 92 | 100 | 0 | .... | 70 | 78 | 86 | 94 | **-1** | **-1** | **0** | **0** | -1 | -1 | -1 | -1 | -1 | -1 |
| 4 | 63 | 66 | 69 | 72 | 75 | 78 | .... | 91 | 94 | 97 | 100 | **-1** | **-1** | **-1** | **0** | **0** | -1 | -1 | -1 | -1 | -1 |
| 5 | 72 | 84 | 96 | 0 | 11 | 23 | .... | 75 | 87 | 99 | 2 | **<u>0</u>** | **-1** | **-1** | **-1** | **0** | **0** | -1 | -1 | -1 | -1 |
| 6 | 65 | 70 | 75 | 80 | 85 | 90 | .... | 39 | 44 | 49 | 54 | **-1** | **-1** | **-1** | **-1** | **-1** | **0** | **0** | -1 | -1 | -1 |
| 7 | 62 | 64 | 66 | 68 | 70 | 72 | .... | 8 | 10 | 12 | 14 | **-1** | **-1** | **-1** | **-1** | **-1** | **-1** | **0** | **0** | -1 | -1 |
| 8 | 69 | 78 | 87 | 96 | 105 | 5 | .... | 44 | <u>-1</u> | 62 | 71 | **-1** | **-1** | **-1** | **-1** | **-1** | **-1** | **-1** | **0** | **0** | -1 |
| 9 | 61 | 62 | 63 | 64 | 65 | 66 | .... | 34 | 35 | 36 | 37 | **-1** | **-1** | **-1** | **-1** | **-1** | **-1** | **-1** | **-1** | **0** | **0** |
| 10 | 76 | 92 | 0 | 15 | 31 | 47 | .... | 80 | 96 | 3 | 19 | **37** | **-1** | **-1** | **-1** | **-1** | **-1** | **-1** | **-1** | **-1** | **0** |

FIG. 11 - $H_{exp-2}$

Europäisches
Patentamt

European
Patent Office

Office européen
des brevets

**EUROPEAN SEARCH REPORT**

Application Number

EP 09 10 0161

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | IEEE: "IEEEStd 802.16e-2005, Air Interface For Fixed and Mobile Broadband Wireless Access Systems , Amendment 2 and Corrigendum 1 to IEEE Std 802.16-2004" IEEE STD 802.16E-2005,, 28 February 2006 (2006-02-28), pages 626-630, XP002515198 * page 626 - page 629 * | 1-4 | INV. H03M13/11 H03M13/03 |
| A | SHASHA E ET AL: "Multi-Rate LDPC code for OFDMA PHY" INTERNET CITATION, [Online] XP002334837 Retrieved from the Internet: URL:http://www.ieee802.org/16/tge/contrib/C80216e-04_185.pdf> [retrieved on 2005-07-05] * page 1 - page 3 * | 1-4 | |
| A | HANSEN AND B EDWARDS C: "WWise Proposal: High throughput extension to the 802.11 Standard" INTERNET CITATION, [Online] XP002396346 Retrieved from the Internet: URL:ftp://802wirelessworld.com/11/04/11-04-0886-06-000n-wwise-proposal-ht spec.doc> [retrieved on 2006-08-25] * page 58 - page 61 * * page 85 - page 98 * | 1-4 | |
| A | US 2006/129904 A1 (BLANKENSHIP YUFEI W [US] ET AL BLANKENSHIP YUFEI W [US] ET AL) 15 June 2006 (2006-06-15) * paragraph [0035] - paragraph [0043] * | 1-4 | TECHNICAL FIELDS SEARCHED (IPC) H03M |
| A | US 2007/094580 A1 (LIVSHITZ MICHAEL [US]) 26 April 2007 (2007-04-26) * abstract; figure 10 * | 1-4 | |

The present search report has been drawn up for all claims

| Place of search | Date of completion of the search | Examiner |
|---|---|---|
| Munich | 12 May 2009 | Burkert, Frank |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

**ANNEX TO THE EUROPEAN SEARCH REPORT
ON EUROPEAN PATENT APPLICATION NO.**

EP 09 10 0161

This annex lists the patent family members relating to the patent documents cited in the above-mentioned European search report.
The members are as contained in the European Patent Office EDP file on
The European Patent Office is in no way liable for these particulars which are merely given for the purpose of information.

12-05-2009

| Patent document cited in search report | Publication date | Patent family member(s) | Publication date |
|---|---|---|---|
| US 2006129904 A1 | 15-06-2006 | EP 1829222 A1 | 05-09-2007 |
| | | KR 20070086301 A | 27-08-2007 |
| | | WO 2006065286 A1 | 22-06-2006 |
| US 2007094580 A1 | 26-04-2007 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0842549452223 A

**Non-patent literature cited in the description**

- *IEEE Std 802.16e - Air Interface for Fixed and Mobile Broadband Wireless Access Systems,* 28 February 2006

- **Jon G. Proakis.** DIGITAL COMMUNICATIONS. Mc-Graw-Hill, 2001